# EUROPEAN PATENT APPLICATION

(11) **EP 2 472 680 A1**
(43) Date of publication of application: **04.07.2012**
(21) Application number: 10844509.9
(22) Date of filing: 27.01.2010
(51) Int. Cl.: H01S 5/022

(54) **SEMICONDUCTOR LASER MODULE**

(71) Applicant: Mitsubishi Electric Corporation, Tokyo 100-8310 (JP)
(72) Inventor: TAMAYA, Motoaki, Tokyo 100-8310 (JP); NAKAMURA, Akira, Tokyo 100-8310 (JP); NANBA, Chise, Tokyo 100-8310 (JP)
(74) Representative: Popp, Eugen
(86) International application number: PCT/JP2010/000455
(87) International publication number: WO 2011/092735

(57) **Abstract**

In order to obtain a semiconductor laser module in which breakage is not made in a cooling process during sealing with glass, magneto-striction deformation is in an acceptable range, and a large current can be flown, the semiconductor laser module includes: a semiconductor laser element (10) which emits light by the supply of a current; a package base (1) having a through hole (1A); a lead pin (2) which passes through the through hole (1A) and supplies the current to the semiconductor laser element (10); a glass material (3) which seals the through hole (1A) through which the lead pin (2) passes through; and a cap (30) which has a window (31) from which light emitted by the semiconductor laser element (10) is taken out and has the semiconductor laser element (10) in the inside thereof, the cap (30) being hermetically joined to the package base (1). The lead pin (2) is an iron-nickel alloys in which the coefficient of linear expansion is not higher than a predetermined ratio in difference with the glass material (3), the saturation magneto-striction constant is not higher than a predetermined value, and volume resistivity is not higher than a predetermined rate.

## Description

The present invention relates to a semiconductor laser module in which a semiconductor laser element which emits light by the supply of a current is hermetically sealed.

### BACKGROUND ART

In semiconductor lasers for use in a machining field or the like, an increase in output has been strongly required. There are many examples in which the increase in output is generally achieved by stacking an array in which a large number of semiconductor lasers are arranged in one element or by broadening which broadens a light emitting area. In the semiconductor lasers of such a structure, respective laser elements are generally arranged electrically parallel; and therefore, a current which flows through the laser element becomes large as the increase in output is progressed and, in recent years, there is also an example in which a current value is approximately several tens of amperes.

When the semiconductor laser module is aired out, deterioration of an element end surface or deterioration of a wire bonding portion is advanced due to moisture or the like; and therefore, the semiconductor laser module is often contained in an hermetic package. Such a package includes: a component generally referred to as a "stem" which is composed of a base portion and a lead pin; and a cap provided with a window from which laser light is taken out. There are many cases where the lead pin is joined and fixed to the base portion by an insulation seal material such as glass and the cap is joined and fixed to the base portion by electric resistance welding.

The cap and the base portion of the stem are generally made of carbon steel or iron-nickel alloy in consideration of welding quality. Furthermore, with regard to the material of the lead pin, in a cooling process from a temperature of approximately 1000°C at which the glass is melted till returning to ordinary temperature during sealing process with glass or in the case where a temperature change is generated during using, in order to prevent a glass portion from breaking down due to a difference in the coefficient of linear expansion, the base portion and the lead pin need to use material which is close to the glass member in the coefficient of linear expansion as much as possible. Therefore, in the case where the iron-nickel alloy is used as the material of the lead pin, an iron-nickel alloy in which the nickel content is approximately 50% by mass that is close to the base portion in the coefficient of linear expansion is used.

Furthermore, in the case where a large current is supplied to the semiconductor laser module, magneto-striction deformation under the influence of a magnetic field is generated, the magnetic field being generated by the current flowing through the lead pin when the lead pin is a magnetic material. More particularly, in the case where an alternating current or a pulse current is supplied, repeated deformation due to magneto-striction is generated in the lead pin; and therefore, there is a case where a crack is generated due to fatigue at a boundary surface between the lead pin and the glass material or at the glass material itself. Further, in the case where frequency of the alternating current or the pulse current is in a zone of audibility of the person, the repeated deformation of the lead pin causes a sound source depending on a housing in which the semiconductor laser module is located and a locating method; and thus, a problem exists in that the sound source is amplified by the surrounding housing or the like to generate noises.

In order to solve the aforementioned problem, it is conceivable that a non-magnetic material is used for the lead pin. In Patent Document 1, copper, aluminum, titanium, austenitic stainless steel, and their alloys are disclosed as the lead pin material. In Patent Document 2, a nickel-molybdenum alloy (hastelloy) or nickel-chromium-molybdenum alloy is disclosed as the lead pin material.

### RELATED ART DOCUMENT

### PATENT DOCUMENT

Patent Document 1: Japanese Unexamined Patent Publication No. 2003-216887
Patent Document 2: Japanese Unexamined Patent Publication No. 2005-353291

### DISCLOSURE OF THE INVENTION

### PROBLEMS TO BE SOLVED BY THE INVENTION

However, the coefficients of linear expansion of the materials of the copper, aluminum, and austenitic stainless steel disclosed in Patent Document 1 are as follows: 19×10⁻⁶ [/K] of copper, 23×10⁻⁶ [/K] of aluminum, 8.4×10⁻⁶ [/K] of titanium, and 16.4×10⁻⁶ [/K] of austenitic stainless steel, respectively. All the coefficients except for titanium have a large difference with respect to the coefficient of linear expansion 9.5×10⁻⁶ [/K] of borosilicate glass and soda-lime glasses, both of which being used as a sealing glass; and accordingly, a problem exists in that there is a case where a crack is generated at the boundary portion between the lead pin and the glass material or at the glass material due to a difference in the amount of heat shrinkage in the cooling process during sealing with glass and thus hermetic seal cannot be sufficiently kept. Titanium is difficult to be refined and processed and is expensive.

Volume resistivities of the titanium and austenitic stainless steel disclosed in Patent Document 1 and volume resistivities of the nickel-molybdenum alloys and nickel-chromium-molybdenum alloys disclosed in Patent Document 2 are as follows: 53 [µ Ω ·cm] of titanium, 74 [µ Ω ·cm] of austenitic stainless steel, and 110 [µ Ω ·am] of nickel-molybdenum alloys and nickel-chromium-molybdenum alloys, respectively. The volume resistivities are equal to or more than 10 times as compared to 1.7 [µ Ω ·cm] of copper which is generally used for large current wiring; and accordingly, a problem exists in that there is a case where hermetic seal cannot be sufficiently kept, for example, when a large current flows, a wiring material is elongated or contracted due to temperature rise by the Joule heat at the wiring portion and a crack is generated between the lead pin and the glass material.

In order to avoid the problem caused by the heat generation of the lead pin described above, a method of reducing wire resistance of the lead pin by enlarging the diameter of the lead pin through which the current flows, is also conceivable. However, when the diameter of the lead pin is equal to or more than approximately 1 mmϕ, it becomes difficult to ensure hermetic seal itself; and therefore, the large current needs to be flown through the lead pin having the diameter of approximately 1 mmϕ at a maximum.

The present invention has been made to solve the foregoing problem, and an object of the present invention is to provide a semiconductor laser module using hermetic terminals in which breakage is not made in a cooling process during sealing with glass, magneto-striction deformation is in an acceptable range, and a large current can be flown.

### MEANS FOR SOLVING THE PROBLEMS

According to the present invention, there is provided a semiconductor laser module which includes a semiconductor laser element which emits light by the supply of a current; a package base having a through hole; a lead pin which passes through the through hole and supplies the current to the semiconductor laser element; a glass material which seals the through hole through which the lead pin passes through; and a cap which has a window from which light emitted by the semiconductor laser element is taken out and has the semiconductor laser element in the inside thereof, the cap being hermetically joined to the package base. In the semiconductor laser module, the lead pin is an iron-nickel alloys in which the coefficient of linear expansion is not higher than a predetermined ratio in difference with the glass material, the saturation magneto-striction constant is not higher than a predetermined value, and volume resistivity is not higher than a predetermined rate.

### ADVANTAGEOUS EFFECT OF THE INVENTION

A semiconductor laser module according to the present invention includes a semiconductor laser element which emits light by the supply of a current; a package base having a through hole; a lead pin which passes through the through hole and supplies the current to the semiconductor laser element; a glass material which seals the through hole through which the lead pin passes through; and a cap which has a window from which light emitted by the semiconductor laser element is taken out and has the semiconductor laser element in the inside thereof, the cap being hermetically joined to the package base. In the semiconductor laser module, the lead pin is an iron-nickel alloys in which the coefficient of linear expansion is not higher than a predetermined ratio in difference with the glass material, the saturation magneto-striction constant is not higher than a predetermined value, and volume resistivity is not higher than a predetermined rate, whereby, breakage is not made in a cooling process during sealing with glass, magneto-striction deformation is in an acceptable range, and a large current can be flown.

### BRIEF DESCRIPTION OF THE DRAWINGS

Fig. 1 is a sectional view showing the configuration of a semiconductor laser module according to Embodiment 1 of the present invention;
Fig. 2 is a graph showing the relationship between the nickel content of iron-nickel alloy and the saturation magneto-striction constant;
Fig. 3 is a graph showing the relationship between the nickel content of iron-nickel alloy and the coefficient of linear expansion;
Fig. 4 is a graph showing the relationship between the nickel content of iron-nickel alloy and volume resistivity;
Fig. 5 is a graph showing the relationship between the nickel content of iron-nickel alloy and thermal conductivity; and
Fig. 6 is a view for explaining material characteristics of materials available for a lead pin and other materials.

### MODE FOR CARRYING OUT THE INVENTION

A semiconductor laser module of the present embodiment of the present invention will be described with reference to drawings.

### Embodiment 1.

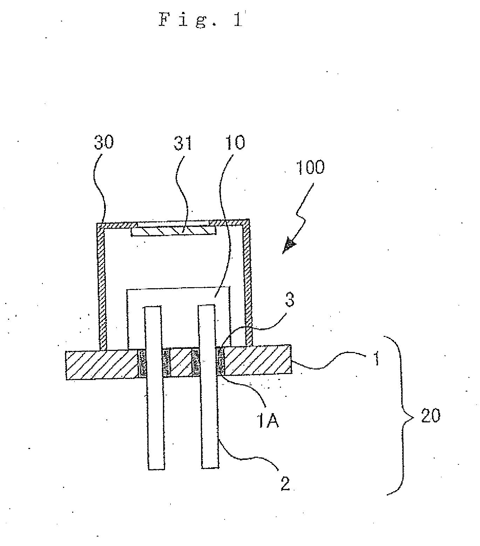

Fig. 1 is a sectional view showing the configuration of a semiconductor laser module 100 in the present embodiment. In Fig. 1, in the semiconductor laser module 100, a cap 30 is provided with a glass window 31 from which light emitted by a semiconductor laser element 10 is taken out and the cap 30 is hermetically joined to a package base 1 to which the semiconductor laser element 10 which emits the light by the supply of a current is fixed.

A predetermined number of circular through holes 1A are formed in the package base 1, one lead pin 2 passes through each of the through holes 1A and a glass material 3 is embedded in the through hole 1A around the lead pin 2. The package base 1 where the lead pins 2 are passed through and fixed, is an hermetic terminal 20 referred to as a "stem."

A carbon steel or an iron-nickel alloys in which the nickel content is approximately 50% by mass is used as a material of the package base 1 and the cap 30; and a soda-lime glasses is used as the glass material 3. Furthermore, a material of the lead pin 2 is an iron-nickel alloys in which the nickel content is approximately 78.5% by mass (78 permalloy or permalloy A) which is particularly near zero in saturation magneto-striction constant and the maximum in initial magnetic permeability, among iron-nickel alloys in which the nickel content is 70 to 85% by mass (PC permalloy) regulated by standard "JIS C 2531, 1999: Iron nickel soft magnetic materials."

The coefficient of linear expansion of the soda-lime glasses serving as the material of the glass material 3 is 9.5×10⁻⁶ [/K]; however, the coefficient of linear expansion of the carbon steel or the iron-nickel alloys in which the nickel content is approximately 50% by mass, serving as the material of the package base 1 also has a value of 11.1×10⁻⁶ [/K] which is near to that of the soda-lime glasses. Furthermore, the coefficient of linear expansion of the permalloy A serving as the material of the lead pin 2 also has a value of approximately 12×10⁻⁶ [/K] which is near to that of the soda-lime glasses.

Now, a method of manufacturing the hermetic terminal 20 for use in the semiconductor laser module 100 in the present embodiment will be briefly described. First, the through hole 1A is formed at a predetermined position of the package base 1. Subsequently, the lead pin 2 is located at the center of the through hole 1A. The melted glass material 3 is poured into the through hole 1A around the lead pin 2 to seal the through hole 1A. The glass material 3 is solidified and the hermetic terminal 20 is completed at ordinary temperature.
The semiconductor laser element 10 is fixed at the predetermined position of the package base 1 with adhesive or the like; and the lead pin 2 and the semiconductor laser element 10 are connected by wiring therebetween. After that, covering is made by the cap 30; dry air or the like is filled; and the package base 1 and the cap 30 are joined by electric resistance welding. Thus, the semiconductor laser module 100 is completed.

As described above, in the case of melting the glass material 3 during manufacturing of the hermetic terminal 20, the temperature reaches a high temperature of approximately 1000°C in order to melt the glass material 3; and therefore, the nearer the coefficients of linear expansion of the package base 1, the glass material 3, and the lead pin 2 are, the smaller the stress at ordinary temperature becomes.
The semiconductor laser module 100 of the present embodiment is composed of the package base 1, the glass material 3, and the lead pin 2, those of which are small in difference between the coefficients of linear expansion. Therefore, stress generated in a sealing process with glass is small; and thus, a crack is difficult to generate between the glass material 3 and the lead pin 2 and between the glass material 3 and the package base 1.

Next, the case where the semiconductor laser module 100 is driven by applying an alternating current or a pulse current to the lead pin 2 will be described.
When the current flows through the lead pin 2, a magnetic field is generated in the inside of the lead pin 2 by the current. Deformation is generated in the lead pin 2 in response to the saturation magneto-striction constant inherent to the material under the influence of the magnetic field. The material of the lead pin 2 in the present embodiment is the permalloy A which is small in saturation magneto-striction constant; and therefore, magneto-striction deformation is hardly generated. As a result, fatigue fracture of a glass seal portion due to deformation and the generation of noise are not generated.

Furthermore, the lead pin 2 in the present embodiment is the permalloy A; and therefore, volume resistivity can be reduced to 15 [µ Ω ·cm] that is approximately 42% as compared to the iron-nickel alloy in which the nickel content is approximately 50% by mass that has been generally used in the past. Therefore, even when a large current flows through the lead pin 2, the amount of heat generation of the lead pin 2 can be reduced and thus the amount of expansion and contraction due to the heat generation of the lead pin 2 can be reduced. As a result, an hermetic package with high reliability can be obtained without generating fatigue fracture of the glass seal portion during driving of the laser module.
According to the present embodiment, for example, even when a large average current of 5A continuously flows through the lead pin 2 having 1 mmϕ, a high reliability semiconductor laser module in which hermetic seal is hardly broken due to the generation of a crack can be obtained.

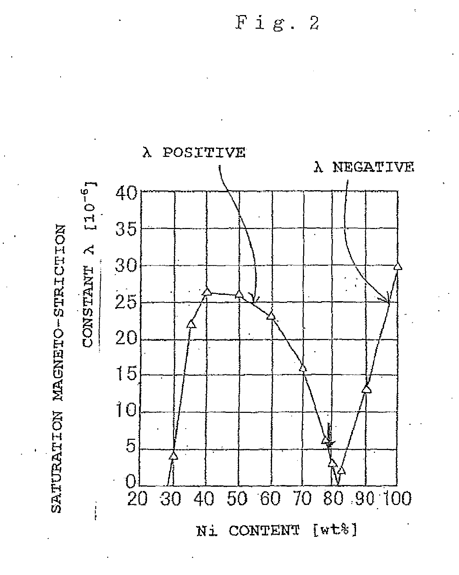

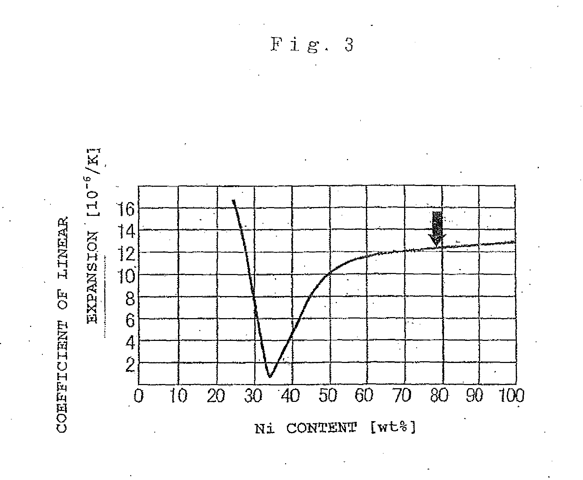

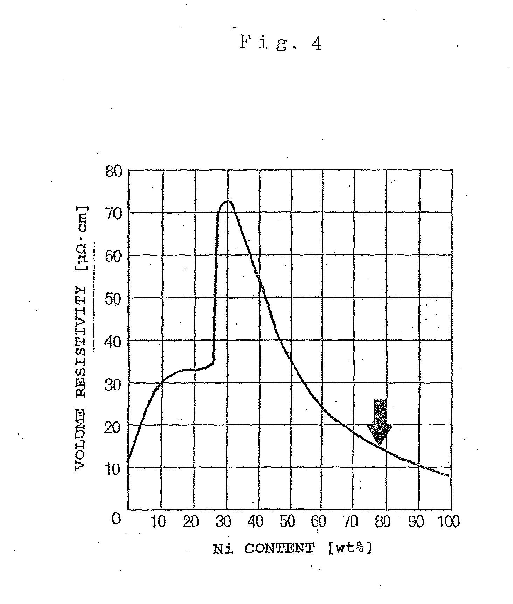

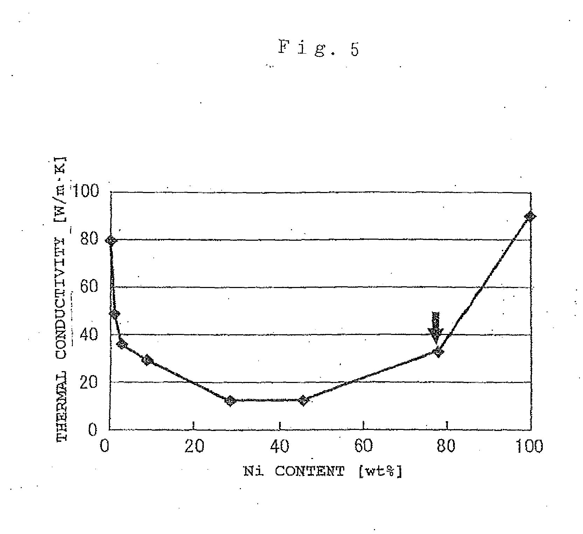

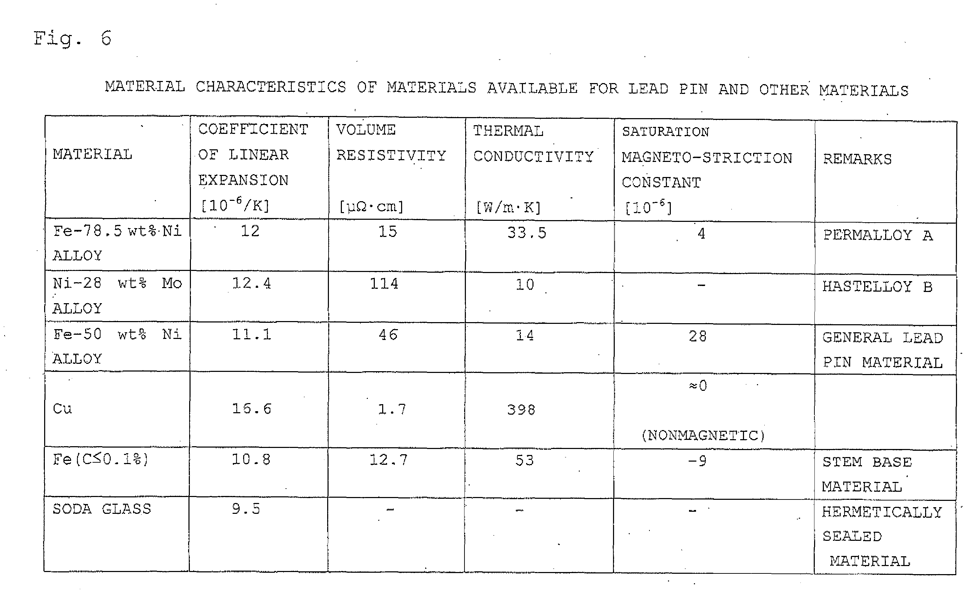

The reason why the permalloy A is adopted for the material of the lead pin 2. Fig. 2 is a graph showing the relationship between the nickel content in the iron-nickel alloy and the saturation magneto-striction constant. Fig. 3 is a graph showing the relationship between the nickel content in the iron-nickel alloy and the coefficient of linear expansion. Fig. 4 is a graph showing the relationship between the nickel content in the iron-nickel alloy and volume resistivity. Fig. 5 is a graph showing the relationship between the nickel content in the iron-nickel alloy and thermal conductivity. Fig. 6 is a view for explaining material characteristics of materials available for the lead pin and other materials.

The coefficient of linear expansion of the permalloy A is 12×10⁻⁶ [/K] and is different with respect to 10.8×10⁻⁶ [/K] of iron and 9.5×10⁻⁶ [/K] of soda-lime glass, each material being served as the material of the package base 1; and the differences are an increase of 11.1% and an increase of 26.3%, respectively, each increase being in an acceptable range. Therefore, when the melted glass material is solidified, stress of the glass material generated due to the difference between the coefficients of linear expansion can be lowered to a level at which a crack or the like is not generated. The saturation magneto-striction constant of the permalloy A is approximately 5×10⁻⁶ and is approximately 1/4 with respect to approximately 20×10⁻⁶ of the case where the nickel content is 50% by mass (Fe-50 wt% Ni alloy). Volume resistivity of the permalloy A is 15 [µ Ω ·cm] and is approximately 42% with respect to approximately 35 [µ Ω ·cm] of the case of the Fe-50 wt% Ni alloy. Thermal conductivity of the permalloy A is 33.5 [W/m·K] and is approximately 2.39 times with respect to 14 [W/m·K] of the case of the Fe-50 wt% Ni alloy.

As is apparent from Fig. 2 to Fig. 6, an iron-nickel alloy in which the saturation magneto-striction constant is near zero, the coefficient of linear expansion is a value near to that of the glass material, and the volume resistivity is small as much as possible, is the case where the nickel content is approximately 80% by mass. The reason why the permalloy A in which the nickel content is 78.5% by mass is adopted for the material of the lead pin 2 is that the permalloy A is excellent in machine workability such as rolling and cutting, easy to obtain materials and to form in a pin shape, and capable of producing inexpensively.

Even if the permalloy A is not available, as far as an iron-nickel alloy is one regulated by standards such as the Japanese Industrial Standard (JIS) and the International Electrotechnical Commission (IEC), such iron-nickel alloys is easier to obtain than a substandard alloy. In the case of JIS, an iron-nickel alloys in which the nickel content is 70 to 85% by mass (PC permalloy) regulated in "JIS C 2531, 1999: Iron nickel soft magnetic materials" is preferable. In the case of the IEC, an iron-nickel alloys in which the nickel content is 72 to 83% by mass, regulated as a type of E11 in "IEC 60404-8-6, 1999: Soft metal magnetic materials" is preferable.

As the material of the lead pin, an iron-nickel alloys in which the coefficient of linear expansion is not higher than a predetermined ratio in difference with the sealing glass material, the saturation magneto-striction constant is not higher than a predetermined value, and the volume resistivity is not higher than a predetermined rate, is preferable. Larger thermal conductivity is preferable so as to transfer Joule heat at the lead pin and heat generation due to light emission at the semiconductor laser element to the outside of the package. In the iron-nickel alloys, in order to have an optional function, a material to which elements such as molybdenum, chromium, copper, and niobium are added to the iron-nickel material up to approximately 10% by mass, may be used.

Furthermore, an iron-nickel alloy in which the nickel content is near 30 % by mass is also substantially zero in the saturation magneto-striction constant; and therefore, a similar effect can be obtained. However, volume resistivity is 75 [µ Ω ·cm]; and therefore, such iron-nickel alloys is not suitable for other than the case where the diameter of the lead pin can be increased or the length of the lead pin can be shortened in the case of applying a large current.

### DESCRIPTION OF REFERENCE NUMERALS

- 100: Semiconductor laser module
- 10: Semiconductor laser element
- 1: Package base
- 1A: Through hole
- 2: Lead pin
- 3: Glass material
- 20: Hermetic terminal
- 30: Cap
- 31: Glass window

## Claims

1. A semiconductor laser module comprising:
a semiconductor laser element which emits light by the supply of a current;
a package base having a through hole;
a lead pin which passes through the through hole and supplies the current to said semiconductor laser element;
a glass material which seals the through hole through which said lead pin passes through; and
a cap which has a window from which light emitted by said semiconductor laser element is taken out and has said semiconductor laser element in the inside thereof, said cap being hermetically joined to said package base,
wherein said lead pin is an iron-nickel alloys in which the coefficient of linear expansion is not higher than a predetermined ratio in difference with said glass material, the saturation magneto-striction constant is not higher than a predetermined value, and volume resistivity is not higher than a predetermined rate.

2. The semiconductor laser module according to Claim 1,
wherein said lead pin is within a range in which the nickel content is regulated by standards.

3. The semiconductor laser module according to Claim 2,
wherein said lead pin has the nickel content which is equal to or higher than 70% by mass and equal to or lower than 85% by mass.

4. The semiconductor laser module according to Claim 2,
wherein said lead pin has the nickel content which is equal to or higher than 72% by mass and equal to or lower than 83% by mass.
